# FASCICULE DE BREVET EUROPEEN

(11) **EP 0 290 345 B1**
(45) Date de publication et mention de la délivrance du brevet: **07.09.1994**
(21) Numéro de dépôt: 88401097.6
(22) Date de dépôt: 05.05.1988
(51) Int. Cl.: H01L 29/46, H01L 31/04, C03C 17/23

(54) **Film électroconducteur pour élément photovoltaique**
Leitende Schicht für photovoltaische Elemente
Conductive layer for photovoltaic elements

(30) Priorité: 07.05.1987 JP 111471/87
(43) Date de publication de la demande: 09.11.1988
(73) Titulaire: SAINT-GOBAIN VITRAGE INTERNATIONAL, 92400 Courbevoie (FR)
(72) Inventeur: Kawahara, Hidéo, Toyonaka-Shi Osaka (JP); Misonou, Masao, Nishinomiya-Shi Hyogo (JP); Hirata, Masahiro, Takatsuki-Shi Osaka (JP)
(74) Mandataire: Leconte, Jean-Gérard

(56) Documents cités:
- EP-A- 0 214 024
- EP-A- 0 216 703
- EP-A- 0 234 222
- GB-A- 2 033 357
- US-A- 4 338 482
- JOURNAL OF THE ELECTROCHEMICAL SOCIETY vol. 132, no. 6, juin 1985, pages 1398 - 1405, Manchester, New Hampshire, US; D. BELANGER et al.: "Thickness Dependence of Transport Properties of Doped Polycrystalline Tin Oxide Films"
- THIN SOLID FILMS vol. 113, no. 2, mars 1984, pages 93 - 100, Lausanne, CH; G. MMAVRODIEV et al.: "Properties of Sn02:F Films Prepared on Glass Substrates by the Spraying Method"
- PATENT ABSTRACTS OF JAPAN vol. 12, no. 69 (E-587)(2916), 3 mars 1984 & JP - A- 62 211 966

## Description

La présente invention concerne un film électroconducteur transparent à deux couches composées principalement d'oxyde d'étain. Plus précisément, elle porte sur un film électroconducteur transparent pour pile solaire.

Une pile solaire bon marché constituée d'un élément convertisseur photovoltaïque en silicium amorphe (a-Si) déposé sur un substrat électroconducteur transparent avec des électrodes en aluminium est connue. Une telle pile solaire à a-Si a un plus faible rendement en conversion photovoltaïque que d'autres piles solaires ayant un semi-conducteur cristallin.

Pour l'améliorer, plusieurs mesures sont possibles. L'une consiste à augmenter au maximum la transmission de l'électrode transparente vis-à-vis de la lumière incidente et de réduire la résistance électrique de surface. Comme couche électroconductrice transparente à faible résistance de surface, une couche d'oxyde d'étain dopée au fluor (désignée ci-après "couche SnO₂:F") a déjà été proposée. Toutefois le dopage de la couche d'oxyde d'étain avec le fluor fait diminuer sa capacité de transmission de la lumière. Donc ce dopage apparaît comme un inconvénient si l'on veut obtenir une couche électroconductrice transparente à faible résistance électrique et en même temps des performances élevées en transmission.

Pour résoudre ce problème, le document de brevet japonais publié sous le n° 62-211966 propose d'utiliser comme électrode transparente déposée sur un substrat un film électroconducteur transparent à deux couches (désigné ci-après "film à 2 couches SnO₂:Cl - SnO₂:F") constitué d'une couche superficielle d'oxyde d'étain n'ayant pas d'halogène autre que le chlore (désigné ci-après "couche SnO₂:Cl") et d'une couche sous jacente d'étain dopé au fluor (désigné ci-après "couche SnO₂:F) déposée directement sur le substrat transparent. Du fait que le rapport de l'épaisseur de la couche d'oxyde d'étain dopé au fluor à l'épaisseur de la totalité du film transparent à deux couches est inférieur à 50%, on peut obtenir un film électroconducteur transparent d'une plus faible résistance de surface que dans le cas d'un film en une seule couche de SnO₂:Cl de même épaisseur globale et d'une plus haute transmission que dans le cas d'un film en une seule couche de SnO₂:F de même épaisseur globale. Par conséquent, dans le cas de l'emploi d'un film à 2 couches SnO₂:Cl/SnO₂:F comme électrode transparente, le rendement en conversion photovoltaïque d'une pile solaire est amélioré, comparé au cas dans lequel on emploie un film à une seule couche de SnO₂:Cl ou de SnO₂:F.

Toutefois, du fait que la couche SnO₂:Cl a une plus grande résistance de surface que la couche SnO₂:F, dans le cas d'une pile solaire employant comme électrode transparente un film à deux couches dont la couche superficielle est une couche de SnO₂:Cl, l'amélioration du rendement en conversion photovoltaïque est limitée.

Par ailleurs, il est connu de la demande de brevet EP-A-0 234 222, déposée le 14 janvier 1987 sous priorité du 25 février 1986 et publiée le 2 septembre 1987, un film électroconducteur composé d'une première couche d'oxyde d'étain non dopé déposée sur un substrat transparent et surmontée d'une seconde couche d'oxyde d'étain dopé par des impuretés comme du fluor, du chlore ou de l'antimoine.

La présente invention vise à résoudre le problème précité.

Elle a également pour but de fournir un film électroconducteur transparent pour élément photovoltaïque apte à augmenter le rendement de conversion photovoltaïque. Ces buts sont atteints au moyen d'un film tel que defini dans les jeux de revendications pour les états désignés DE, FR, GB et pour les états désignés BE, ES, IT, NL, SE.

Avantageusement la couche composée principalement d'oxyde d'étain et ne contenant pas de fluor est une couche SnO₂:Cl, c'est-à-dire une couche ne contenant pas d'halogène sauf du chlore obtenue à partir d'un composé d'étain contenant aucun halogène sauf du chlore ou d'un composé d'étain sans chlore auquel on ajoute un apporteur de chlore tel HCl.

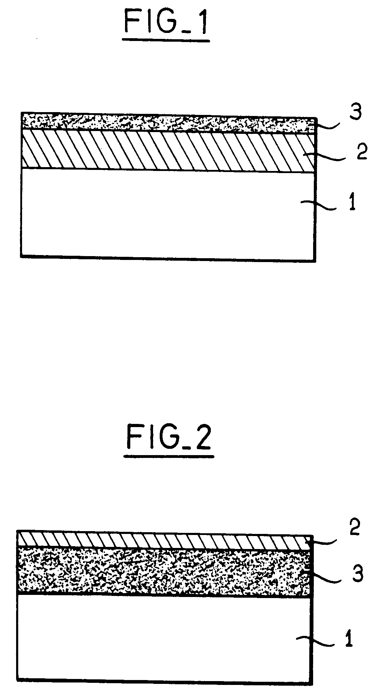

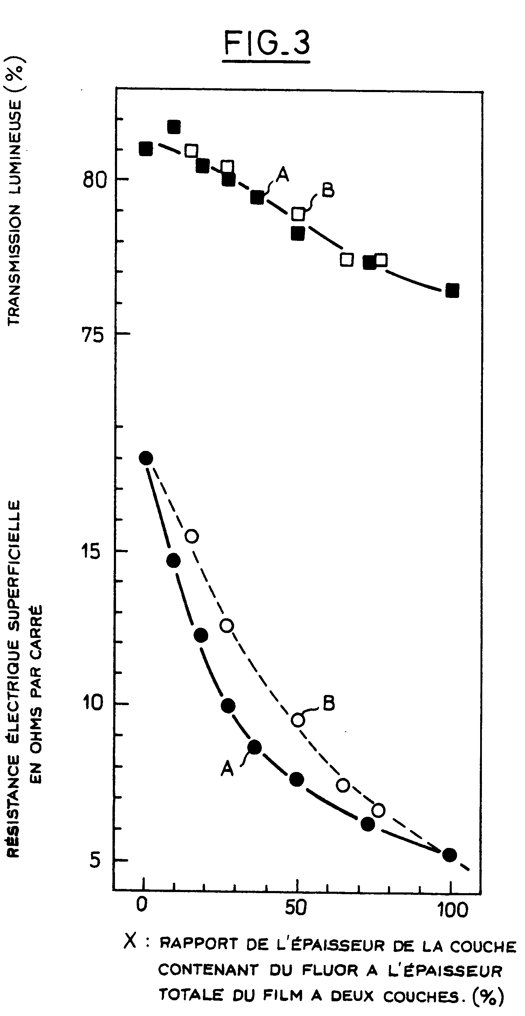

L'invention sera maintenant décrite plus en détail en référence aux figures jointes qui représentent :
. **figure 1** : un film à deux couches conforme à l'invention déposé sur un substrat,
. **figure 2** : un film à deux couches, classique,
. figure 3 : un graphique montrant pour différents films classiques et selon l'invention, les valeurs des caractéristiques de transmission lumineuse et de résistance électrique superficielle, cela pour différents valeurs du rapport X de l'épaisseur de la couche SnO₂:F à l'épaisseur totale du film.

Pour réaliser le dépôt du film à deux couches, on chauffe le substrat, on le met en contact avec le composé d'étain chloré ou sans chlore ni aucun autre halogène, mais avec un appoint d'apporteur de Cl, ce qui permet d'obtenir la première couche SnO₂:Cl. Puis on chauffe à nouveau le substrat partiellement revêtu et on le met en contact avec un composé d'étain fluoré ou avec un composé d'étain et un composé fluoré pour obtenir la seconde couche SnO₂:F.

Comme composés d'étain utilisables pour le dépôt de la couche SnO₂:Cl, on peut citer C₄H₉SₙCl₃, SnCl₄, (CH₃)₂SnCl₂, etc parmi les composés chlorés, et on peut citer (CnH₂ₙ₊₁)₄Sn avec n = 1 à 4, (CH₃)₂SnH₂, (C₄H₉)₃SnH, (C₄H₉)₂Sn(COOCH₃)₂, etc, comme composés sans chlore auxquels on fait un appoint avec un apporteur de chlore tel HCL.

Pour déposer la couche SnO₂:F, on peut utiliser tous les composés d'étain précités à condition de faire un appoint de donneur de fluor : CH₃CH₂F₂, CHClF₂, CH₃CCLF₂, CHF₃, CF₂Cl₂, CF₃Cl, CF₃Br.

Pour mettre ces composés d'étain en contact avec des substrats transparents chauffés et pour provoquer l'oxydation et la décomposition thermique, on utilise la méthode de dépôt chimique en phase gazeuse (méthode CVD) par laquelle on met une vapeur de composés d'étain et un gaz oxydant en contact avec un substrat transparent à haute température, ou bien la méthode de pulvérisation par laquelle on pulvérise une solution du composé d'étain, sur le substrat transparent à haute température à l'aide d'un pulvérisateur.

On utilise de préférence la méthode CVD par laquelle on met un mélange de vapeur de composés d'étain, de gaz oxydant, etc... en contact avec le substrat transparent chauffé à une température de 400 à 600°C. On dépose ainsi un film électroconducteur transparent à deux couches, c'est-à-dire, une couche SnO₂:Cl puis une autre couche SnO₂:F, déposée en recouvrement.

Selon la présente invention, l'épaisseur du film à deux couches SnO₂:F/SnO₂:Cl est de 0.6 à 1.0 micron. Toutefois, pour améliorer le rendement de conversion photovoltaïque, il est préférable que le rapport de l'épaisseur de la couche SnO₂:F sur celle de la totalité du film soit de plus de 5%, mais toutefois inférieure à 50%, et de préférence, de plus de 10%. Quand le rapport d'épaisseur précité est inférieur à 5%, le rendement de conversion photovoltaïque baisse sensiblement.

Du fait que la couche électroconductrice transparente superficielle est une couche SnO₂:F, on peut obtenir un film électroconducteur transparent dont la transmission lumineuse est identique à celle d'un film à deux couches SnO₂:Cl/SnO₂:F d'une même épaisseur totale et ayant un même rapport d'épaisseur de la couche SnO₂:F vis-à-vis de l'épaisseur totale, mais pour lequel l'ordre des couches est inversé, mais dont la résistance électrique superficielle est plus faible. Il en résulte qu'on peut améliorer le rendement de conversion photovoltaïque. Ainsi par exemple on a fabriqué des échantillons et on a comparé les performances.

On a bien lavé et séché des plaques de verre à base de soude et de chaux revêtues d'une couche d'oxyde de silicium, d'une taille de 25 mm x 30 mm et d'une épaisseur de 1.1 mm. On les a utilisées comme substrats de verre. Puis, on a déposé un film électroconducteur transparent sur ces substrats de verre selon les procédés suivants.

En utilisant un mélange de vapeur de monobutyle trichlorure d'étain, de vapeur d'eau, d'oxygène et d'azote, on a déposé par CVD une couche SnO₂:Cl sur les substrats de verre chauffés à 550°C. Puis, on a chauffé à 550° C ces substrats de verre revêtus de cette couche SnO₂:Cl et déposé par CVD une autre couche SnO₂:F sur la première couche d'oxyde d'étain n'ayant pas d'halogène autre que le chlore en utilisant un mélange de vapeur de monobutyle trichlorure d'étain, de vapeur d'eau, d'oxygène, de 1,2-difluoroéthane et d'azote, on a ainsi obtenu un film SnO₂:F/SnO₂:Cl.

Sur la figure 1, on indique la structure d'un tel film électroconducteur transparent deux couches SnO₂:F.SnO₂:Cl. 1 est la référence du substrat en verre, 2 est la couche SnO₂:Cl, 3 est la couche SnO₂:F.

En changeant la durée de dépôt de chacune des couches SnO₂:Cl et SnO₂:F et en conservant toujours une épaisseur totale du film à deux couches de 0,85 micron, on a obtenu des rapports x de l'épaisseur de la couche SnO₂:F sur l'épaisseur de la totalité du film, qui étaient de 0, 9, 18.5, 27, 36, 49.5, 73 et 100 %. Ces échantillons sont désignés "A".

A titre comparatif, on a déposé des films à deux couches SnO₂:Cl/SnO₂:F, c'est-à-dire ayant la structure inversée. On a obtenu 5 échantillons pour lesquels les rapports d'épaisseur x précités étaient de 15, 26.5, 50, 65 et 76%. Ces échantillons sont désignés "B".

On a mesuré la transmission du rayonnement visible et la résistance électrique de surface des ces échantillons A et B. Sur la figure 3, on indique les résultats de ces mesures. D'après la figure 3, il est clair que les transmissions de "A" et celle de "B" sont identiques pour des valeurs de x identiques et que la résistance électrique de surface de "A" est plus faible que celle de "B" pour une même valeur de x.

Il en résulte que selon la présente invention, on peut obtenir des films électroconducteurs transparents de faible résistance électrique et autorisant une importante transmission lumineuse.

L'invention peut être appliquée pour réaliser des piles solaires, mais également pour d'autres applications photovoltaïques.

## Revendications (Revendications pour l'(les) Etat(s) contractant(s) suivant(s): BE, ES, IT, NL, SE)

1. Film électroconducteur transparent à deux couches (2, 3), **caractérisé en ce qu**'il est constitué d'une couche électroconductrice transparente (3) composée principalement d'oxyde d'étain comprenant du fluor déposée au-dessus d'une autre couche électroconductrice transparente (2) étant composée principalement d'oxyde d'étain ne comprenant pas de fluor et étant déposée au-dessus d'un substrat transparent (1).

2. Film électroconducteur transparent à deux couches (2, 3) selon la revendication 1, **caractérisé en ce que** la couche électroconductrice transparente composée principalement d'oxyde d'étain (2) ne comprenant pas de fluor est une couche électroconductrice transparente composée d'oxyde d'étain ne comprenant pas d'halogène autre que le chlore.

3. Film électroconducteur transparent à deux couches (2, 3) selon l'une des revendications 1 ou 2, **caractérisé en ce que** l'épaisseur de ce film est de 0,6 micron à 1,0 micron.

4. Film électroconducteur transparent à deux couches (2, 3) selon la revendication 3, **caractérisé en ce que** le rapport x de l'épaisseur de la couche composée principalement d'oxyde d'étain (3) comprenant du fluor à l'épaisseur totale du film à deux couches (2, 3) est supérieur ou égal à 5 % et inférieur à 50 %.

5. Film électroconducteur transparent à deux couches (2, 3) selon la revendication 4, **caractérisé en ce que** le rapport x est supérieur à 10 %.

6. Application du film selon l'une des revendications précédentes à la réalisation de piles solaires et en général d'éléments photovoltaïques.

## Revendications (Revendications pour l'(les) Etat(s) contractant(s) suivant(s): DE, FR, GB)

1. Film électroconducteur transparent à deux couches (2, 3), **caractérisé en ce qu**'il est constitué d'une couche électroconductrice transparente (3) composée principalement d'oxyde d'étain comprenant du fluor déposée au-dessus d'une autre couche électroconductrice transparente (2) étant composée principalement d'oxyde d'étain ne comprenant pas de fluor ni d'halogène autre que le chlore et étant déposée au-dessus d'un substrat transparent (1).

2. Film électroconducteur transparent à deux couches (2, 3) selon la revendication 1, **caractérisé en ce que** l'épaisseur de ce film est de 0,6 micron à 1,0 micron.

3. Film électroconducteur transparent à deux couches (2, 3) selon la revendication 2, **caractérisé en ce que** le rapport x de l'épaisseur de la couche (3) composée principalement d'oxyde d'étain comprenant du fluor à l'épaisseur totale du film à deux couches (2, 3) est supérieur ou égal à 5 % et inférieur à 50 %.

4. Film électroconducteur transparent à deux couches (2, 3) selon la revendication 3, **caractérisé en ce que** le rapport x est supérieur à 10 %.

5. Application du film selon l'une des revendications précédentes à la réalisation de piles solaires et en général d'éléments photovoltaïques.

## Patentansprüche (Patentansprüche für folgende(n) Vertragsstaat(en): BE, ES, IT, NL, SE)

1. Elektroleitfähiger transparenter Film aus zwei Schichten (2,3) **dadurch gekennzeichnet**,**daß** er aus einer elektroleitfähigen transparenten Schicht (3), die im wesentlichen aus fluorhaltigem Zinnoxid besteht und auf einer weiteren elektroleitfähigen transparenten Schicht (2) abgeschieden wird, die im wesentlichen aus Zinnoxid ohne Fluorgehalt besteht und auf einem transparenten Substrat (1) abgeschieden wird.

2. Elektroleitfähiger transparenter Film aus zwei Schichten (2,3) nach Anspruch 1 **dadurch gekennzeichnet, daß** die elektroleitfähige transparente im wesentlichen aus Zinnoxid bestehende Schicht (2) ohne Fluorgehalt eine elektroleitfähige transparente aus Zinnoxid bestehende Schicht ist, die kein Halogen außer Chlor enthält.

3. Elektroleitfähige transparenter Film aus zwei Schichten (2,3) nach Anspruch 1 oder 2, **dadurch gekennzeichnet, daß** die Dicke des Films 0,6 bis 1,0 µm ist.

4. Elektroleitfähiger transparenter Film aus zwei Schichten (2,3) nach Anspruch 3, **dadurch gekennzeichnet, daß** das Verhältnis x der Dicke der im wesentlichen aus fluorhaltigem Zinnoxid (3) bestehenden Schicht zur Gesamtdicke des Films aus zwei Schichten (2,3) größer oder gleich 5 % und kleiner als 50 % ist.

5. Elektroleitfähiger transparenter Film aus zwei Schichten (2,3) nach Anspruch 4, **dadurch gekennzeichnet, daß** das Verhältnis x größer 10 % ist.

6. Verwendung des Films nach einem der vorhergehenden Ansprüche zur Herstellung von Solarzellen und im allgemeinen von Photovoltaik-Elementen.

## Patentansprüche (Patentansprüche für folgende(n) Vertragsstaat(en): DE, FR, GB)

1. Elektroleitfähiger transparenter Film aus zwei Schichten (2,3), **dadurch gekennzeichnet, daß** er aus einer elektroleitfähigen transparenten Schicht (3), die im wesentlichen aus fluorhaltigem Zinnoxid besteht und auf einer weiteren elektroleitfähigen transparenten Schicht (2) abgeschieden wird, die im wesentlichen aus Zinnoxid besteht, das weder Fluor noch ein Halogen außer Chlor enthält und die auf einem transparenten Substrat (1) abgeschieden wird.

2. Elektroleitfähiger transparenter Film aus zwei Schichten (2,3) nach Anspruch 1, **dadurch gekennzeichnet**, **daß** die Dicke des Films 0,6 bis 1,0 µm beträgt.

3. Elektroleitfähiger transparenter Film aus zwei Schichten (2,3) nach Anspruch 2, **dadurch gekennzeichnet, daß** das Verhältnis x der Dicke der im wesentlichen aus fluorhaltigem Zinnoxid bestehenden Schicht (3) zur Gesamtdicke des Films aus zwei Schichten (2,3) größer oder gleich 5 % und kleiner 50 % ist.

4. Elektroleitfähiger transparenter Film aus zwei Schichten (2,3) nach Anspruch 3, **dadurch gekennzeichnet, daß** das Verhältnis x größer 10 % ist.

5. Verwendung des Films nach einem der vorhergehenden Ansprüche zur Herstellung von Solarzellen und im allgemeinen von Photovoltaik-Elementen.

## Claims (Claims for the following Contracting State(s): BE, ES, IT, NL, SE)

1. Transparent electrically conducting film comprising two layers (2, 3), characterized in that it is constituted of a transparent electrically conducting layer (3) composed principally of tin oxide containing fluorine deposited over another transparent electrically conducting layer (2) being composed principally of tin oxide comprising no fluorine and being deposited onto a transparent substrate (1).

2. Transparent electrically conducting film comprising two layers (2, 3) according to Claim 1, characterized in that the transparent electrically conducting layer composed principally of tin oxide (2) containing no fluorine is a transparent electrically conducting layer composed of tin oxide containing no halogen other than chlorine.

3. Transparent electrically conducting film comprising two layers (2, 3) according to one of Claims 1 or 2, characterized in that the thickness of this film is from 0.6 micron to 1.0 micron.

4. Transparent electrically conducting film comprising two layers (2, 3) according to Claim 3, characterized in that the ratio x of the thickness of the film composed principally of tin oxide (3) containing fluorine to the total thickness of the film comprising two layers (2, 3) is greater than or equal to 5% and less than 50%.

5. Transparent electrically conducting film comprising two layers (2, 3) according to Claim 4, characterized in that the ratio x is greater than 10%.

6. Application of the film according to one of the preceding-Claims to the production of solar cells and in general photovoltaic elements.

## Claims (Claims for the following Contracting State(s): DE, FR, GB)

1. Transparent electrically conducting film comprising two layers (2, 3), characterized in that it is constituted of a transparent electrically conducting layer (3) composed principally of tin oxide comprising fluorine deposited over another transparent electrically conducting layer (2) being composed principally of tin oxide containing no fluorine nor any halogen other than chlorine and being deposited onto a transparent substrate (1).

2. Transparent electrically conducting film comprising two layers (2, 3) according to Claim 1, characterized in that the thickness of this film is from 0.6 micron to 1.0 micron.

3. Transparent electrically conducting film comprising two layers (2, 3) according to Claim 2, characterized in that the ratio x of the thickness of the layer (3) composed principally of tin oxide containing fluorine to the total thickness of the film comprising two layers (2, 3) is greater than or equal to 5% and less than 50%.

4. Transparent electrically conducting film comprising two layers (2, 3) according to Claim 3, characterized in that the ratio x is greater than 10%.

5. Application of the film according to one of the preceding Claims to the production of solar cells and in general photovoltaic elements.
